# EUROPÄISCHE PATENTSCHRIFT

(11) **EP 0 886 783 B1**
(45) Veröffentlichungstag und Bekanntmachung des Hinweises auf die Patenterteilung: **27.03.2002**
(21) Anmeldenummer: 96919691.4
(22) Anmeldetag: 07.05.1996
(51) Int. Cl.: G01R 31/06

(54) **SCHALTUNGSANORDNUNG ZUR FEHLERSTROMERKENNUNG**
FAULT CURRENT RECOGNITION CIRCUITRY
AGENCEMENT DE CIRCUITS PERMETTANT DE RECONNAITRE UN COURANT DE DEFAUT

(30) Priorität: 01.06.1995 DE 19526435
(43) Veröffentlichungstag der Anmeldung: 30.12.1998
(73) Patentinhaber: Continental Teves AG & Co. oHG, 60488 Frankfurt (DE)
(72) Erfinder: ZYDEK, Michael, D-35428 Langgöns (DE); FEY, Wolfgang, D-65527 Niedernhausen (DE); ENGELMANN, Mario, D-61449 Steinbach (DE); ZINKE, Olaf, D-65719 Steinbach (DE)
(74) Vertreter: Blum, Klaus-Dieter, Dipl.-Ing.
(86) Internationale Anmeldenummer: EP9601896
(87) Internationale Veröffentlichungsnummer: WO9638736

(56) Entgegenhaltungen:
- DE-A- 4 242 177

## Beschreibung

Die Erfindung bezieht sich auf eine Schaltungsanordnung, die zur Erkennung eines Fehlerstroms auf der Versorgungsleitung einer elektronischen Schaltung dient und die mit einer Hilfsspannungsquelle sowie mit einem Potentialmonitor zur Ermittlung und Auswertung des während einer Meßphase auf der Versorgungsleitung herrschenden- Potentials ausgerüstet ist.

Aus der DE 42 42 177 A1 (P 7433) ist bereits eine derartige Schaltungsanordnung bekannt, die zur Überwachung einer Vielzahl von Ventilspulen und der zugehörigen Endstufen dient. Zur Fehlerstromerkennung wird eine Hilfsspannungsquelle über einen hochohmigen Widerstand an die gemeinsame Versorgungsleitung für die Ventilspulen angeschlossen und das Potential auf dieser Versorgungsleitung gemessen und ausgewertet. Zuvor wurde der Anschluß dieser Versorgungsleitung an die Versorgungsquelle, nämlich die Fahrzeugbatterie, mit Hilfe eines Halbleiter-Relais unterbrochen. Der zugehörige Potentialmonitor ist über einen hochohmigen Spannungsteiler angeschlossen. Bei einem Nebenschluß oder einem Leckstrom von der Versorgungsleitung zur Versorgungsquelle oder zur Masse hin ändert sich das Potential auf der Versorgungsleitung.

Der Erfindung liegt nun die Aufgabe zugrunde, eine Schaltungsanordnung dieser Art zu entwickeln, die sich durch hohe Genauigkeit, Empfindlichkeit und Zuverlässigkeit bei der Erkennung von Fehlerströmen, zu denen auch die Leckströme zählen, auszeichnet und die außerdem mit verhältnismäßig geringem Aufwand zu realisieren ist. Es sollte eine einfache und damit preisgünstige Meßeinrichtung zur Überwachung des Potentials auf der Versorgungsleitung genügen.

Es hat sich gezeigt, daß sich diese Aufgabe durch die in Anspruch 1 beschriebene Ausbildung einer derartigen Schaltungsanordnung lösen läßt. Das Besondere dieser Schaltungsanordnung besteht darin, daß durch Einfügung einer Stromquelle, die für einen maximal zulässigen Strom ausgelegt ist, vorzugsweise von zwei antiparallelgeschalteten Einzelstromquellen, das Ansprechen der Überwachung verhindert wird, solange der Fehlerstrom innerhalb vorgegebener Grenzwerte liegt, daß jedoch bei einer selbst geringen Überschreitung dieser Grenzwerte bereits eine sehr deutliche und daher leicht auswertbare Potentialänderung auf der Versorgungsleitung während der Prüfphase hervorgerufen wird.

Nach einem besonders vorteilhaften Ausführungsbeispiel der Erfindung werden zwei auf Fehlerströme in entgegengesetzte Richtung ansprechende Einzelstromquellen verwendet, wodurch sichergestellt ist, daß sowohl Fehlerströme, bzw. Nebenschlüsse von der Versorgungsleitung zum positiven Pol der Versorgungsquelle als auch zur Masse hin erkannt werden.

Die erfindungsgemäße Schaltungsanordnung ist zum Beispiel zur Überwachung der Ventilspulen und der zugehörigen elektronischen Schaltungen einer geregelten Bremsanlage, bei der die Spulen über eine gemeinsame Versorgungsleitung und über ein gemeinsames Relais an die Versorgungsspannung angeschlossen sind, besonders geeignet. Bei einer solchen Bremsanlage muß das Erkennen eines Fehlerstroms mit hoher Sicherheit gewährleistet sind, weil in einem Fehlerfall die Regelung abgeschaltet werden muß, um die Funktion der Bremsanlage aufrechtzuerhalten. Es handelt sich also um eine sicherheitskritische Anwendung.

Weitere Merkmale, Vorteile und Anwendungsmöglichkeiten der Erfindung gehen aus der folgenden Beschreibung eines Ausführungsbeispiels anhand der beigefügten Abbildungen hervor.

Es zeigen:
- Fig. 1: schematisch vereinfacht die wesentlichen elektrischen Komponenten einer Schaltungsanordnung nach der Erfindung,
- Fig. 2: das Blockschaltbild einer Überwachungsschaltung auf Basis der Schaltungsanordnung nach Fig. 1,
- Fig. 3: im Diagramm den Signalverlauf in Abhängigkeit von dem Fehlerstrom bei einer Schaltungsanordnung nach Fig. 1 oder 2,
- Fig. 4: die Prinzipschaltung eines Potentialmonitors für die Schaltungsanordnungen nach Fig. 1 oder 2, und
- Fig. 5: in Prinzipdarstellung einen Teil eines integrierten Schaltkreises zur Verwirklichung von Stromquellen für die Schaltungsanordnung nach Fig. 1 oder 2 und
- Fig. 6: in gleicher Darstellungsweise wie Fig. 5 eine Variante des Schaltkreises nach Fig. 5.

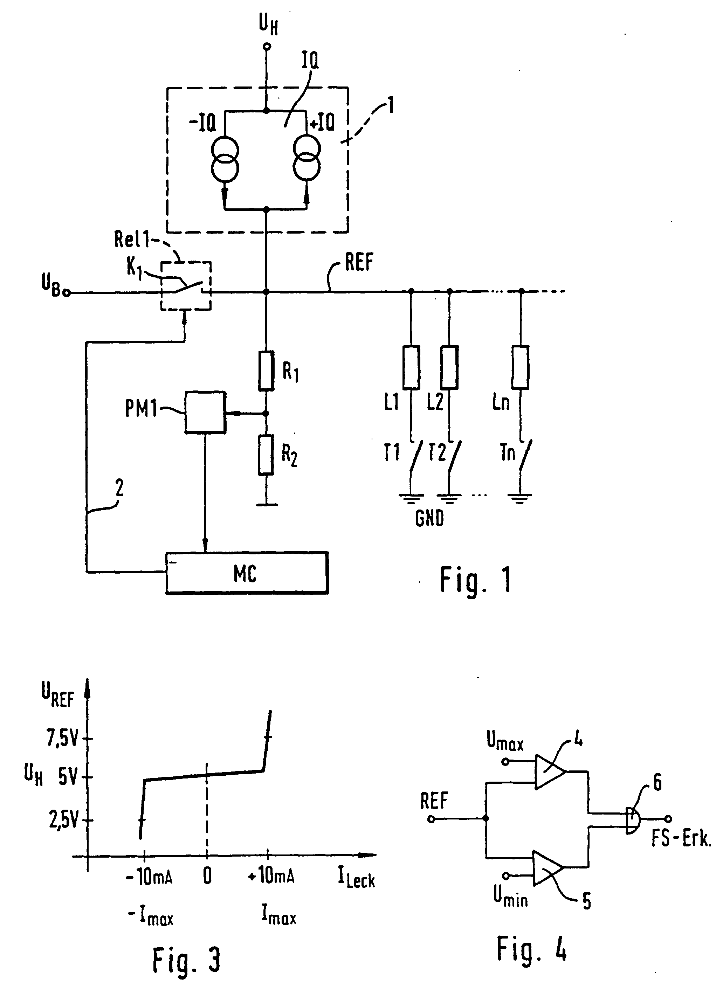

Fig. 1 dient zur Veranschaulichung der prinzipiellen Arbeitsweise der erfindungsgemäßen Schaltungsanordnung. Mit L1, L2, Ln sind die Ventilspulen bezeichnet, die zu den Hydraulikventilen eines Kraftfahrzeug-Regelungssystems, zum Beispiel einer blockiergeschützten Bremsanlage (ABS) gehören und die zur Bremsdruckmodulation dienen. Diese Spulen werden mit Hilfe von Schaltern oder Endstufen T1, T2, Tn ein- und ausgeschaltet. Zur Energieversorgung ist eine gemeinsame Versorgungsleitung REF über ein Relais Rel1 mit einem Arbeitskontakt K_{**1**} an eine Versorgungsquelle, nämlich an eine Fahrzeugbatterie mit der Spannung U_{**B**} angeschlossen. Der Kontakt K_{**1**} ist nur dann geschlossen und die Blockierschutzregelung nur dann in Funktion, solange kein Fehler vorliegt.

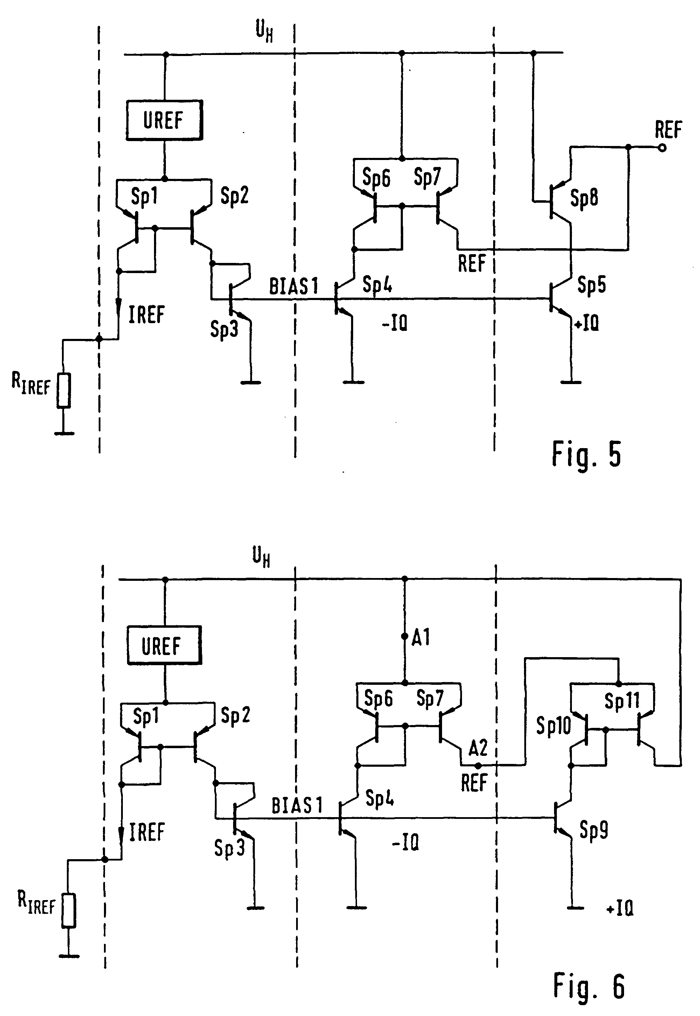

Zum Erkennen eines Fehlerstroms ist eine Überwachungsschaltung 1 vorgesehen, von der in Fig. 1 lediglich eine aus zwei Einzelstromquellen -IQ, +IQ bestehende Stromquelle IQ dargestellt ist. Diese Überwachungsschaltung 1 ist an eine Hilfsspannungsquelle U_{**H**} angeschlossen. Da das Potential dieser Hilfsspannungsquelle U_{**H**} unter dem Potential der Batteriespannung U_{**B**} und über dem gemeinsamen Massepotential GND liegt, sind bei einem Nebenschluß von der Versorgungsleitung REF zum Massepotential GND einerseits und bei einem Nebenschluß von der Versorgungsleitung REF zur Batteriespannung U_{**B**} Fehlerströme in entgegengesetzer Richtung möglich. Aus diesem Grund besteht die Stromquelle IQ im dargestellten Ausführungsbeispiel aus zwei antiparallelgeschalteten Einzelstromquellen -IQ und +IQ. Bei geöffnetem Rel1 bzw. K_{**1**} und offenen Schaltern T1, T2, Tn wird bei einem Nebenschluß von der Versorgungsleitung REF zur Masse GND ein Stromfluß über die Einzelstromquelle -IQ hervorgerufen, bei einem Nebenschluß zur Versorgungsspannung +U_{**B**} über die Einzelstromquelle +IQ. Das Potential auf der Versorgungsleitung REF wird dabei, wie nachstehend anhand der Fig. 3 erläutert wird, (nahezu) auf dem Potential U_{**H**} gehalten, aber nur solange der Betrag des Fehlerstromes kleiner ist als ein vorgegebener Grenzwert bzw. nur solange der Fehlerstrom zwischen vorgegebenen Grenzwerten ± I_{**max**} liegt. "+I_{**max**}" und "-I_{**max**}" sind die "Nennströme" der Stromquellen "+IQ" bzw. "-IQ".

Steigt der Betrag des Fehlerstromes über diese Grenzen ± I_{**max**} an, führt dies zu einer steilen Änderung des Potentials auf der Versorgungsleitung REF. Diese Potentialänderung wird über einen Spannungsteiler R_{**1**}, R_{**2**} dem Eingang eines Potentialmonitors PM1 signalisiert. Mit Hilfe dieses Potentialmonitors PM1 und eines Mikrocomputers MC, der noch weitere, hier nicht beschriebene Prüf- bzw. Überwachungsaufgaben erfüllt, wird die Potentialänderung ausgewertet und, sobald ein Fehler erkannt wird, über eine Signalleitung 2 das Öffnen des Relais Rel1 veranlaßt bzw. das Schließen des Kontaktes K_{**1**} dieses Relais verhindert. Auf diese Weise wird das Ansprechen der Ventile, zu denen die Spulen L1, L2, Ln gehören, unterbunden und damit die Regelung außer Funktion gesetzt.

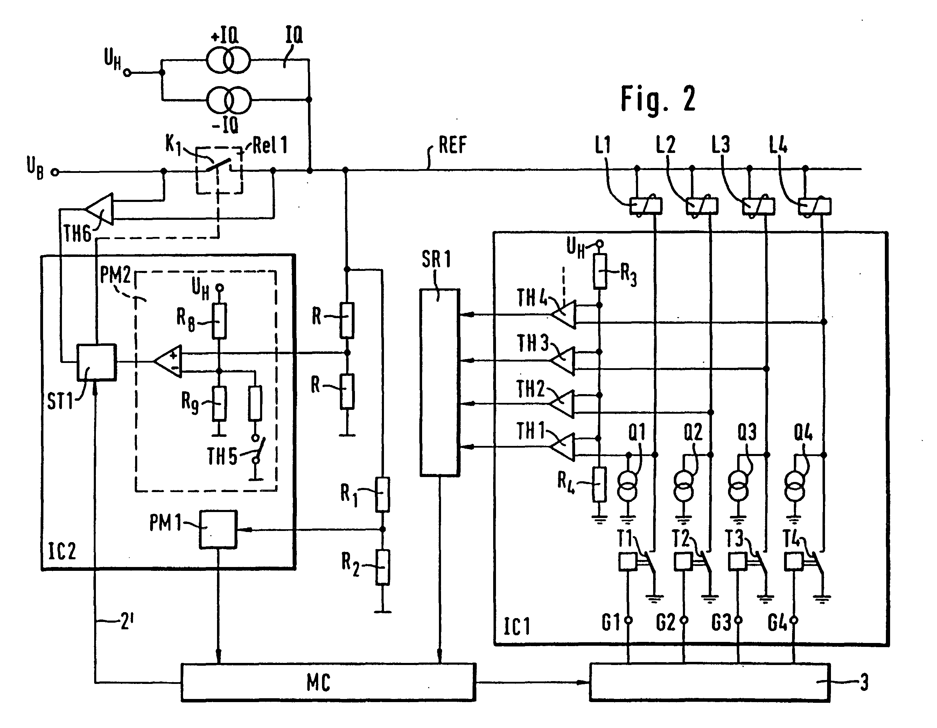

Fig. 1 und Fig. 2 zeigen die gleiche Schaltungsanordnung, wobei in Fig. 1 lediglich die für die Erfindung wesentlichen Komponenten, in Fig. 2 dagegen weitere Details wiedergegeben sind.

Endstufen zum Ein- und Ausschalten des Erregerstroms für die Ventilspulen L1 bis L4 sind in Fig. 2 durch die Schalter T1 bis T4 symbolisiert, die über Anschlüsse G1 bis G4 angesteuert bzw. betätigt werden.

Mit Hilfe von Komparatoren TH1 bis TH4 wird festgestellt, ob das Potential am Ausgang der Schalter oder Transistoren T1 bis T4 über oder unter einem vorgegebenen Schwellwert liegt, der mit Hilfe der Hilfsspannungsquelle U_{**H**} und eines Spannungsteilers R_{**3**}, R_{**4**} definiert wird. Bei geöffnetem Schalter T1 bis T4 wird das Potential an dem entsprechenden Eingang der Komparatoren TH1 bis TH4 im dargestellten Ausführungsbeispiel durch Stromquellen Q1 bis Q4 festgelegt.

Die Ausgangspegel der Komparatoren TH1 bis TH4 werden über ein Schieberegister SR1 erfaßt und seriell zu dem Mikrocomputer MC weitergeleitet. In entsprechender Weise werden Testpulse von dem Mikrocomputer MC über einen Wandler 3 den Steueranschlüssen G1 bis G4 der Schalter bzw. Transistoren T1 bis T4 zugeleitet. Wie bereits anhand der Fig. 1 erläutert wurde, sind die Ventilspulen L1 bis L4 über das Relais Rel1 an die Fahrzeugbatterie mit der Spannung U_{**B**} angeschlossen.

Das Potential auf der Versorgungsleitung REF wird mit Hilfe von zwei Potentialmonitoren PM1 und PM2, die über Spannungsteiler an die Versorgungsleitung REF angeschlossen sind, festgestellt und überwacht. Die Funktion des Potentialmonitors PM1 wurde bereits anhand der Fig. 1 beschrieben. Der zweite Potentialmonitor PM2 ist als Fensterkomparator mit umschaltbarer Schwelle ausgebildet. Zur Schwellenumschaltung dient ein Schalter TH5. Das Ausgangssignal des Komparators PM2 wird in einer Steuereinheit ST1 in ein Signal zur Betätigung des Halbleiter-Relais Rel1 umgesetzt. Ein Ausgang des Mikrocomputers MC führt über eine Leitung 2' zu der Steuereinheit ST1. Beim Erkennen eines Defektes, insbesondere eines Fehlerstroms, wird über die Steuereinheit Sl1 das Rel1 abgeschaltet und damit die Stromversorgung der Ventilspulen L1 bis L4 bzw. L1 bis Ln unterbrochen.
Ein weiterer Komparator TH6 dient zur Erkennung des Schalt zustandes des Relais Rel1.

Die Schaltung nach Fig. 2 arbeitet wie folgt:

Das Relais Rell dient als Hauptrelais. Bei der Betätigung der Zündung wird zunächst der Kontakt K_{**1**} des Rel1 geschlossen. Die dadurch eintretende Potentialänderung auf der Versorgungsleitung REF wird durch den Potentialmonitor PM2 überwacht. Solange kein Nebenschluß besteht, wird bei geöffnetem Kontakt K_{**1**} das Potential auf der Versorgungsleitung REF durch die Hilfsspannungsquelle U_{H} bestimmt. Nach dem Schließen von K_{**1**} stellt sich auf der Versorgungsleitung REF gegenüber Masse die Batteriespannung U_{**B**} ein. U_{**B**} ist wesentlich höher als U_{**H**}.

Nach dem Schließen des Kontaktes K_{**1**} steigt die Spannung am Eingang des Monitors PM2 über die durch die Spannung U_{**H**} und die Widerstände R_{**8**}, R_{**9**} vorgegebene Schwellenspannung am zweiten Eingang des dargestellten Komparators dieses Monitors PM2 an. Der Ausgang des Komparators schaltet auf "high". Danach wird die Schwelle des Komparators mit Hilfe des Schalters TH5 auf einen höheren Wert gesetzt, so daß der Ausgang des Komparators wieder "low" wird. Durch diese low-high-low-Übergänge wird gleichzeitig die Funktion des Monitors PM2 bei ordnungsgemäßer Arbeitsweise des Relais Rel1 getestet. Nach dem Umschalten auf die höhere Schwelle dient der Komparator des Monitors PM2 über die Steuereinheit ST1 zur Betätigung und gegebenfalls Abschaltung des Relais Rell beim Auftreten von Überspannungen auf der Versorgungsquelle U_{B}. Das Anschalten der Ventilspulen L1 bis L4 wird mit Hilfe von kurzen Testpulsen überprüft. Durch diese Testpulse wird der jeweilige Schalter T1 bis T4 geschlossen und die dadurch hervorgerufene Potentialänderung am Eingang des entsprechenden Komparators TH1 bis TH4 in der bereits beschriebenen Weise ausgewertet. Während des Auftretens dieser Testpulse ist der Kontakt K_{**1**} des Relais Rel1 geöffnet.

Die Überwachung der Versorgungsleitung REF auf Nebenschlüsse zur Versorgungsspannungsquelle + U_{**B**} oder zur Masse hin wird in der bereits beschriebenen Weise mit Hilfe der Stromquelle IQ bzw. der Einzelstromquellen +IQ und -IQ ausgeführt.

Fig. 3 zeigt den Potentialverlauf auf der Versorgungsleitung REF in Abhängigkeit von diesen Nebenschlüssen bzw. von den entsprechenden Fehler- oder Leckströmen I_{Leck}. Im vorliegenden Fall beträgt die Spannung der Hilfsspannungsquelle U_{**H**} = 5V. Die Stromquelle IQ ist in diesem Beispiel auf ± 10 mA ausgelegt. Solange der Fehlerstrom innerhalb der Grenzen ± 10 mA liegt, wird das Potential auf der Versorgungsleitung REF durch die Stromquelle IQ auf dem Potential U_{**H**} = 5V gehalten. Sobald jedoch der Strom diesen Wert von ± 10 mA überschreitet, selbst bei sehr geringer Überschreitung, ändert sich das Potential nahezu schlagartig in Richtung auf Massepotential oder in Richtung zur Batteriespannung U_{**B**}. Ein sehr einfacher Potentialmonitor PM1 genügt, um diese Potentialänderung festzustellen und auszuwerten. Die jeweiligen Toleranzen, zum Beispiel der Spannungsteilerwiderstände R1, R2, die tatsächliche Höhe der Batteriespannung U_{**B**} usw., spielen für die Genauigkeit und Zuverlässigkeit der Fehlerstromerkennung keine Rolle.

Ein einfaches Beispiel eines solchen Potentialmonitors zeigt Fig. 4. Das Potential auf der Versorgungsleitung REF wird mit Hilfe von zwei Komparatoren 4, 5 mit vorgegebenen Schwellwerten U_{**max**} und U_{**min**} verglichen. Beim Erreichen der Schwellwerte wird über ein ODER-Gatter 6 ein Fehlerstromerkennungs-Signal abgegeben.

Fig. 5 zeigt ein Beispiel zur Verwirklichung der Stromquelle IQ mit Hilfe eines integrierten Schaltkreises, der Stromspiegelschaltungen enthält.

In bekannter Weise wird mit Hilfe eines externen Widerstandes "R_{**IREF**}" und einer internen Referenzspannung "UREF" ein bestimmter Referenzstrom "IREF" eingestellt. Dieser Schaltkreis ist an die externe Hilfsspannungsquelle U_{**H**} angeschlossen. Mit Hilfe einer Stromspiegelschaltung mit den Transistoren Sp1, Sp2, Sp3 wird in bekannter Weise eine Bezugsgröße BIAS1 erzeugt, die an der Basis der Transistoren Sp4, Sp5 anliegt und den Arbeitspunkt dieser Transistoren bestimmt. Durch Stromspiegelung mit Hilfe der am Kollektor des Transistors Sp4 angeschlossenen, zu einer Stromspiegelschaltung zusammengeschalteten Transistoren Sp6, Sp7 wird eine Einzelstromquelle -IQ und mit Hilfe der hintereinandergeschalteten Transistoren Sp5, Sp8 die Einzelstromquelle +IQ gebildet. Auf diese Weise entsteht eine Stromquelle IQ, die sich gewissermaßen aus zwei antiparallel geschalteten Stromquellen zusammensetzt und die einen Strom vorgegebener Höhe zu einem höheren Potential (+U_{**B**}) oder zu einem niedrigeren Potential (GND) hin liefern kann. Der Nennwert dieser Stromquellen, d.h. der Maximalwert (+I_{**max**}, -I_{**max**}), für den die Stromquellen ausgelegt sind, kann in beiden Richtungen gleich sein, wie im vorliegenden Beispiel, oder es können unterschiedliche Maximalwerte vorgegeben werden.

Integrierte Schaltungen dieser Art sind bekannt. Der relativ große Spannungshub beim Überschreiten der vorgegebenen Strom-Grenzwerte +I_{**max**} bzw. -I_{**max**} mindert die Anforderungen an den Potentialmonitor und verringert die Empfindlichkeit des Überwachungssystems gegenüber Streufeldern (EMV). Der Gesamtaufwand für die Schaltungsanordnung nach der Erfindung wird dadurch vergleichsweise gering.

Fig. 6 zeigt eine Schaltungsvariante, die von dem Schaltkreis nach Fig. 5 nur durch die etwas andere Zusammenschaltung der die rechte Stromquelle +IQ bildenden Transistoren Sp9, Sp10, Sp11 abweicht. Diese Schaltungsvariante veranschaulicht, daß sich die Stromquellen -IQ und +IQ gewissermaßen nur durch die Vertauschung der Anschlüsse A1,A2, die zur Hilfsspannungsquelle U_{**H**} und zum REF-Anschluß führen, unterscheidet. Die Stromquellen -IQ und +IQ sind schaltungsmäßig identisch, die Stromflußrichtungen - durch Vertauschung der Anschlüsse A1,A2 - jedoch gegensätzlich.

## Patentansprüche

1. Schaltungsanordnung zur Erkennung eines Fehlerstroms auf der Versorgungsleitung (REF) einer elektronischen Schaltung, mit einer Hilfsspannungsquelle (U_{**H**}) und mit einem Potentialmonitor (PM1) zur Ermittlung und Auswertung des während einer Meßphase auf der Versorgungsleitung (REF) herrschenden Potentials, **dadurch gekennzeichnet, daß** die Versorgungsleitung (REF) über eine Stromquelle (IQ; +IQ, -IQ), die für einen maximal zulässigen Fehlerstrom ausgelegt ist, an die Hilfsspannungsquelle (U_{**H**}) angeschlossen ist.

2. Schaltungsanordnung nach Anspruch 1, **dadurch gekennzeichnet, daß** das Potential der Hilfsspannungsquelle (U_{**H**}) zwischen dem Potential der Versorgungsspannung (U_{**B**}) und dem Massepotential (GND) liegt und daß die Stromquelle (IQ) aus zwei antiparallelgeschalteten Einzelstromquellen (+IQ, -IQ) besteht, die jeweils für den maximal zulässigen Fehlerstrom einer Richtung ausgelegt sind.

3. Verwendung einer Schaltungsanordnung nach Anspruch 1 oder 2, wobei diese Schaltungsanordnung zur Überwachung der Ventilspulen (L1-L4, Ln) und der zugehörigen elektronischen Schaltungen einer geregelten Bremsanlage, bei der die Spulen (L1-L4, Ln) über eine gemeinsame Versorgungsleitung (REF) und über ein gemeinsames Relais (Rell) an die Versorgungsspannung (U_{**B**}) angeschlossen sind, verwendet wird.

## Claims

1. Circuitry for detecting a fault current on the supply line (REF) of an electronic circuit, including an auxiliary voltage source (U_{H}) and a potential monitor (PM1) for determining and analyzing the potential prevailing on the supply line (REF) during a testing period,
**characterized in that** the supply line (REF) is connected to the auxiliary voltage source (U_{H}) by way of a current source (IQ; +IQ, -IQ) which is rated for a maximum allowed fault current.

2. Circuitry as claimed in claim 1,
**characterized in that** the potential of the auxiliary voltage source (U_{H}) ranges between the potential of the supply voltage (U_{B}) and the ground potential (GND), and **in that** the current source (IQ) includes two anti-parallel connected single current sources (+IQ, -IQ) which are each rated for the maximum allowed fault current of one direction.

3. Employment of a circuitry as claimed in claim 1 or claim 2, the said circuitry being used for monitoring the valve coils (L1-L4, Ln) and the associated electronic circuits of a controlled brake system, wherein the coils (L1-L4, Ln) are connected to the supply voltage (U_{B}) by way of a common supply line (REF) and a common relay (Rel1).

## Revendications

1. Montage pour la détection d'un courant de défaut sur la ligne d'alimentation (REF) d'un circuit électronique, comportant une source de tension auxiliaire (U_{H}) et comportant un moniteur de potentiel (PM1) pour déterminer et exploiter le potentiel régnant sur la ligne d'alimentation (REF) pendant une phase de mesure, **caractérisé en ce que** la ligne d'alimentation (REF) est raccordée à la source de tension auxiliaire (U_{H}) par une source de courant (IQ ; +IQ, -IQ) qui est dimensionnée pour un courant de défaut maximal admissible.

2. Montage selon la revendication 1, **caractérisé en ce que** le potentiel de la source de tension auxiliaire (U_{H}) se situe entre le potentiel de la tension d'alimentation (U_{B}) et le potentiel de masse (GND) et **en ce que** la source de courant (IQ) est constituée de deux sources individuelles de courant (+IQ, -IQ) montées antiparallèles, qui sont dimensionnées chacune pour le courant de défaut maximal admissible d'un sens.

3. Utilisation d'un montage selon la revendication 1 ou 2, ce montage étant utilisé pour la surveillance des bobines de soupape (L1-L4, Ln) et des circuits électroniques correspondants d'un système de freinage régulé, dans lequel les bobines (L1-L4, Ln) sont raccordées à la tension d'alimentation (U_{B}) par un relais (Rel1) commun et par une ligne d'alimentation (REF) commune.
